# EUROPÄISCHE PATENTSCHRIFT

(11) **EP 2 119 329 B1**
(45) Veröffentlichungstag und Bekanntmachung des Hinweises auf die Patenterteilung: **22.02.2012**
(21) Anmeldenummer: 08735161.5
(22) Anmeldetag: 10.04.2008
(51) Int. Cl.: H05K 1/14, H05K 1/18, G02B 6/42

(54) **VORRICHTUNG UND VERFAHREN ZUM AUFBAU OPTOELEKTRONISCHER BAUGRUPPEN**
DEVICE AND METHOD FOR CONSTRUCTING OPTOELECTRONIC ASSEMBLIES
DISPOSITIF ET PROCÉDÉ D'ASSEMBLAGE DE BLOCS OPTOÉLECTRONIQUES

(30) Priorität: 11.04.2007 DE 102007017016
(43) Veröffentlichungstag der Anmeldung: 18.11.2009
(73) Patentinhaber: Fraunhofer-Gesellschaft zur Förderung der angewandten Forschung e.V., 80686 München (DE)
(72) Erfinder: OFFENBECK, Bernd, 93057 Regensburg (DE); WEBER, Norbert, 91367 Weissenohe (DE)
(74) Vertreter: Schenk, Markus
(86) Internationale Anmeldenummer: PCT/EP2008/002853
(87) Internationale Veröffentlichungsnummer: WO 2008/125278

(56) Entgegenhaltungen:
- WO-A-02/12942
- FR-A- 2 890 456
- JP-A- 6 334 298
- KR-A- 20040 025 202
- US-A- 5 857 054
- US-A- 6 125 041
- US-A1- 2001 000 316
- US-A1- 2003 016 920
- US-A1- 2004 033 029

## Beschreibung

Die vorliegende Erfindung bezieht sich auf Vorrichtungen und Verfahren zum Aufbau von optoelektronischen Baugruppen, wie sie beispielsweise bei optischen Sendeempfängern (Transceiver) eingesetzt werden können.

Für eine Übertragung optischer Signale über optische Fasernetzwerke werden kostengünstige optische Transceiver benötigt, um die optischen Signale, insbesondere Licht, in die optischen Faserleitungen einzukoppeln bzw. aus den Faserleitungen zu empfangen. Aufgrund ihrer hohen Übertragungskapazität wächst die Nachfrage nach optischen Übertragungssystemen stetig, was preiswerte optoelektronische Systeme notwendig macht.

Typischerweise werden optoelektronische Niedrigpreissysteme, insbesondere optische Transceiver, auf so genannten Leadframes als Chipträger aufgebaut, was jedoch nur mit oberflächenaktiven Bauteilen, wie beispielsweise oberflächenemittierenden Leucht- oder Laserdioden oder Fotodioden, ohne großen Herstellungsaufwand möglich ist. Oberflächenaktive optische Bauteile weisen eine optisch aktive Oberfläche auf, über die Licht senkrecht zur Ebene des Bauteiles abgestrahlt bzw. empfangen werden kann.

Im Gegensatz dazu kann bei kantenaktiven optischen Bauteilen das Licht an ein oder zwei Flanken des Bauteils aus- bzw. eintreten. Für kantenaktive Bauteile, wie beispielsweise kantenemittierende Laser, wird typischerweise eine so genannte TO-Can-Gehäusetechnik, (TO = Transistor Outline Canister) oder beispielsweise ein aufwendiges Butterflygehäuse eingesetzt.

Für kostensensitive optoelektronische Produkte ist es sinnvoll, bei einer Produktion entweder eine Leadframe-Technik einzusetzen oder eine Chip-on-Board-Technik auf Standardleiterplattenmaterial zu verwenden. Die Chip-on-Board-Technik ist eine Produktionstechnologie, bei der ungehäuste Halbleiter bzw. integrierte Schaltkreise direkt auf eine Leiterplatte geklebt und danach mit Mikrodrähten mit der Leiterplatte verbunden werden. Bei diesen Techniken ist es jedoch nicht ohne weiteres möglich, kantenaktive und oberflächenaktive Bauteile (z.B. Laser- und Fotodioden) gemeinsam auf einer Leiterplatte zu verwenden, da sich Kantenemitter als optisch aktiver Chip in der Regel nur schwer auf einer Leiterplatte verbauen lassen, wenn eine Lichtabstrahlung senkrecht zur Leiterplatte verlaufen soll.

Bei einer Verwendung von optischen Bauelementen in TO-Can-Gehäusen sollten typischerweise sämtliche optischen Bauteile, wie z.B. Laser- und Fotodioden, in dieser Aufbautechnik vorliegen, was einen erheblichen Kostenfaktor darstellt.

Im Falle eines Mischaufbaus, d.h. beispielsweise Fotodiode in Chip-On-Board-Technik und Laser in TO-Can-Technik, sind die Bauhöhen der optisch aktiven Chips nicht kompatibel, so dass eine gemeinsame optische Schnittstelle in einer definierten Ebene kaum zu realisieren ist.

Für eine kostengünstige Realisierung von optoelektronischen Produkten, insbesondere optischen Transceivern, wäre jedoch ein Mischaufbau aus optischen Bauteilen verschiedener Bauteilhöhe, die sowohl in Chip-On-Board-Technik als auch in TO-Can-Technik auf Leiterplatten aufgebracht sind und die optisch aktive Endflächen in einer Ebene aufweisen, wünschenswert. Sind die Endflächen aller optisch aktiven Bauelemente in gleicher Höhe in einem optoelektronischen Modul angebracht, so kann beispielsweise ein optischer Stecker in einfacher Weise mit dem optoelektronischen Modul verbunden werden.

Die US 2004/0033029 A1 zeigt ein Modul mit einer transparenten Basisschicht, in die eine Faserleitung eingeführt wird. Auf der transparenten Basisschicht sind in einem Schichtstapel zwei lateral versetzte Laserdioden mittels transparenten Klebers aufgebracht. Die beiden Laser sind lateral um den Abstand d beabstandet, so dass unterschiedliche Wellenlängen in die Faserleitung eingekoppelt werden können. Die Entgegenhaltung beschreibt nicht genau, wie die Laserdioden bzw. ihre Substrate (die als Leiterplattenflächen interpretiert werden könnten) ausgeführt sind.

Die US 5, 857, 054 beschreibt eine Vorrichtung und ein Verfahren zum entfernbaren Anbringen von einer oder mehreren optischen Fasern, um in Ausrichtung mit einer entsprechenden elektrooptischen Komponente auf einer Schaltungsplatine innerhalb einer Umhüllung zu sein. Bei einem ersten Ausführungsbeispiel ist der Deckel an einer Apertur einer Umhüllung angebracht, wodurch die Schaltungsplatine vor Staub und Flüssigkeiten geschützt wird. Bei einem zweiten Ausführungsbeispiel sind der Deckel und die Schutzumhüllung auf einer einstückigen Einheit. Die Erfindung ermöglicht, dass eine oder mehrere optische Fasern abnehmbar an einer ersten Seite eines Deckels oder Deckel/Umhüllung angebracht sind und eine Schaltungsplatine eine oder mehrere elektrooptische Komponenten aufweist, die präzise darauf positioniert sind, um an der anderen Seite derselben angebracht zu sein und durch die angebrachte Faser durch ein Durchgangsloch in dem Deckel zugegriffen zu werden. Eine Hülse umgibt zumindest eine optische Faser in der Nähe eines Endes derselben und umfasst eine Sitzoberfläche, die auf der Außenseite des Deckels oder von Deckel/Umhüllung sitzt. Wenn zwei optische Fasern mit freien Enden unterschiedlicher Länge durch den Verbinder getragen sind, ermöglichen Hülsen, die an jedem Verbinder angebracht sind, dass die Optikfaserenden genau auf unterschiedlichen Höhen über entsprechenden elektrooptischen Komponenten auf der Schaltungsplatine positioniert sind.

Die WO 02/12942 A1 offenbart eine Vorrichtung oder ein Array aus angeordneten optischen Teilanordnungen, das modulare Einheiten umfasst, die Ein-Kanal-Teilanordnungen genannt werden. Jede der Ein-Kanal-Teilanordnungen umfasst eine optische Teilanordnung mit kleinem Format, die an ein Substrat angebracht ist, und ein optisches Kopplungselement, wobei alle derselben mit einer Basis verbunden sind. Das optische Kopplungselement umfasst ein Fokussierungselement und eine Hülsenaufnahmebohrung. Die angeordnete Vorrichtung macht es möglich, eine der Ein-Kanal-Teilanordnungen zu entfernen oder mit einer anderen Ein-Kanal-Teilanordnung auszutauschen. Die optische Teilanordnung mit kleinem Format der Ein-Kanal-Teilanordnung kann ein Sender oder ein Empfänger sein. Somit ist die Vorrichtung ein modulares, hochdichtes Mehr-Optik-Sender/Empfänger-Array.

Die KR 1020040025202 offenbart ein bidirektionales Optik-Sende-Empfangs-Modul, das eine Einmodenfaser verwendet und einen Träger eines optischen Wellenleiters, der in demselben verwendet wird, die vorgesehen sind, um die Ausführung einer passiven Ausrichtung zu ermöglichen. Gemäß dem bidirektionalen optischen Sende-Empfangs-Modul, das eine Einmodenfaser verwendet, weist ein optischer Wellenleiter einen Spiegel, einen optischen Filter und einen Kern auf, was einen optischen Weg eines gesendeten und empfangenen Lichts bereitstellt. Ein Träger eines optischen Wellenleiters ist mit dem optischen Wellenleiter kombiniert und ist mit einem optischen Kabel verbunden. Ein Modul, das in eine optische Vorrichtung eingebettet ist, ist mit einer lichtemittierenden Vorrichtung und einem Photodetektor eingebettet. Das erste Kombinationsteil kombiniert den optischen Wellenleiter und den Träger des optischen Wellenleiters an einer festen Position, um den Kern und die optische Faser auszurichten, wo eine Licht-Übertragung und ein -Empfang zueinander möglich ist. Und das zweite Kombinationsteil kombiniert den Träger des optischen Wellenleiters und das Modul, das in das optische Element eingebettet ist, an einer festen Position, um den Kern und die lichtemittierende Vorrichtung und den Photodetektor auszurichten, wo eine Licht-Übertragung und ein -Empfang zueinander möglich ist.

Die FR 2 890 456 offenbart eine Vorrichtung für eine hermetisch abgedichtete Kopplung zwischen einer optoelektronischen Komponente, die einen Lichtstrahl emittiert und/oder empfängt, und einer optischen Sendeeinrichtung, die den Lichtstrahl transportiert. Die hermetische Kopplungsvorrichtung weist ein Substrat auf, das mit einem Blindloch versehen ist, mit einer Basiswand, wobei ein Teil der optischen Sendeeinrichtung eingefügt ist. Das Substrat ist durch einen Stapel einer ersten Schicht und einer zweiten Schicht gebildet. Der Lichtstrahl passiert durch die Basiswand des Blindlochs, wobei das Substrat die optoelektronische Komponente im Wesentlichen gegenüberliegend zu dem Blindloch aufnimmt. Reflexionsmuster sind zwischen die zwei Schichten der hermetischen Kopplungsvorrichtung im Wesentlichen an dem Umfang des Blindlochs und dem Reflexionsteil des Lichtstrahls, der durch die optoelektronische Komponente emittiert wird, eingefügt.

Die JP 06334298 versucht das Gewicht von befestigten Teilen zu reduzieren, ohne die Miniaturisierung einer gedruckten Schaltungsplatine zu behindern, beim Befestigen von Teilen auf der Oberfläche der gedruckten Schaltungsplatine. Ein Modul besteht aus einer gedruckten Miniaturschaltungsplatine; Teile sind auf einer Fläche der Platine befestigt, und andere Teile, die groß zumindest im Hinblick auf Befestigungshöhe sind, sind auf der anderen Fläche befestigt. Anschlussflächen sind an dem Umfang der anderen Fläche gebildet. Eine gedruckte Hauptschaltungsplatine weist ein kleines rechteckiges Loch auf, das ähnlich zu und kleiner als die gedruckte Miniaturschaltungsplatine ist. Anschlussflächen sind an dem Umfang des rechteckigen Lochs gebildet. Die hohen Teile sind in das rechteckige Loch eingefügt und das Modul ist auf die gedruckte Hauptschaltungsplatine überlagert. Anschlussflächen sowohl an dem Modul als auch der gedruckten Hauptplatine sind mit einander durch Löten verbunden und somit ist der Erstere an dem Letzteren befestigt.

Die US 6,125,041 beschreibt eine elektronische Vorrichtung vom Kartentyp, die zumindest eine Schaltungsplatine umfasst, wobei die Schaltungsplatine einen Teilbefestigungsabschnitt umfasst, die teilweise von einem Ausschnittabschnitt umgeben ist und mechanisch und elektrisch mit einem anderen Abschnitt der Schaltungsplatine über einen flexiblen Stützabschnitt verbunden ist. Der flexible Stützabschnitt ist so gebogen, dass eine Höhenposition des Teilebefestigungsabschnitts unterschiedlich zu einer Höhenposition eines verbleibenden Abschnitts der Schaltungsplatine ist.

Die US2003016920 beschreibt ein Steckfassungsmodul für die optische Übertragung, das an einem Halterkörper, in den ein spezifiziert Stecker einzusetzen ist, eine optische Halbleitervorrichtung für das Eingeben und Ausgeben eines optischen Signals über den Stecker. Die optische Halbleitervorrichtung ist so konstruiert, dass ein lichtemittierender Chip und ein Lichtempfangschip auf einer Einseitenoberfläche eines Leiterrahmens montiert sind, in dem der lichtemittierende Chip und der Lichtempfangschip integral mit einem Lichtdurchlässigen Harz eingegossen sind. Die Oberfläche des Leiterrahmens in Bezug auf eine Mittelchase des hineingesteckten Steckers geneigt angeordnet.

Die US 2001/000031611 beschreibt eine optische Systemeinheit für einen optischen Transceiver mit einer Sendelinse und einer Empfangslinse, die als gebogene Vorsprünge aus einem optischen transparenten Harzmaterial gebildet sind, wobei sich die distalen Enden der bogenförmigen Vorsprünge jeweils vor einem Ende einer optischen Faser zum Senden und einem Ende einer optischen Faser für den Empfang befinden, welche in einem bestimmten Abstand voneinander angeordnet und in einem einzigen faseroptischen Kabel untergebracht sind, wobei ein Leiterrahmen in dem optisch transparenten Harzmaterial vorgesehen ist und durch Biegen gebildet wird, so dass er zwei Stufen aufweist, wobei die Abstände der zwei Stufen entlang den Achsen der optischen Fasern von dem einen Ende der optischen Faser zum Senden und dem einen Ende der optischen Faser für den Empfang voneinander verschieden sind, und eine Licht emittierende Vorrichtung in dem optisch transparenten Harzma terial vorgesehen und auf einer Stufe des Leiterrahmens angeordnet ist, so dass sie dem einen Ende der optischen Faser zum Senden gegenübersteht, und eine Lichtempfangsvorrichtung in dem optisch transparenten Harzmaterial vorgesehen und auf der anderen Stufe des Leiterrahmens angeordnet ist, so dass sie dem einen Ende der optischen Faser für den Empfang gegenübersteht.

Die Aufgabe der vorliegenden Erfindung besteht somit darin, Vorrichtung und Verfahren bereitzustellen, um optoelektronische Module mit einem Mischaufbau aus ersten optischen Bauteilen mit einer ersten Höhe und zweiten optischen Bauteilen mit einer zweiten von der ersten verschiedenen Höhe bereitzustellen.

Diese Aufgabe wird durch eine Vorrichtung gemäß Patentanspruch 1, ein System gemäß Patentanspruch 10, ein Verfahren gemäß Patentanspruch 12 und einem Satz gemäß Patentanspruch 11 gelöst.

Der vorliegenden Erfindung liegt die Erkenntnis zugrunde, dass optisch aktive Endflächen von optischen Bauteilen mit geringer Bauhöhe und optisch aktive Endflächen von Bauteilen mit höherer Bauhöhe in zumindest näherungsweise eine gleiche Ebene gebracht werden können, in dem die optischen Bauteile mit niedriger Bauhöhe auf einer ersten Leiterplattenfläche angebracht werden können, die über einer zweiten Leiterplattenfläche liegt, auf der die optischen Bauteile mit der höheren Bauhöhe angebracht sind. Die höheren optischen Bauteile der zweiten, tiefer liegenden Leiterplattenfläche können dabei ganz oder teilweise in die darüber liegende erste Leiterplattenfläche hineinragen, wenn in dieser entsprechende Aussparungen bzw. Öffnungen vorgesehen sind.

Bei Ausführungsbeispielen können optische Bauteile also auf unterschiedlichen, im Wesentlichen parallel übereinander bzw. hintereinander liegenden Leiterplattenflächen angebracht werden. Durch Verändern eines Abstands zwischen den Leiterplattenflächen können die optischen Bauteile auf den verschiedenen Leiterplattenflächen in Normalenrichtung zueinander positioniert werden. Dabei bedeutet die Normalenrichtung eine Richtung einer gemeinsamen Normalen der im Wesentlichen parallel übereinander bzw. hintereinander liegenden Leiterplattenflächen.

Gemäß Ausführungsbeispielen kann eine optische Transparenz der Leiterplattenflächen durch geeignete Fenster gewährleistet werden, welche im einfachsten Fall aus Löchern bzw. Öffnungen in den Leiterplattenflächen bestehen. Gemäß Vergleichsbeispielen können in eine Leiterplattenfläche auch Optiken eingelassen sein, um eine optische Transparenz durch die Leiterplattenfläche zu gewährleisten. Eine Leiterplatte bzw. Leiterplattenfläche kann gemäß Vergleichsbeispielen auch ganz oder teilweise transparent ausgeführt sein.

Ein Vorteil der vorliegenden Erfindung besteht darin, dass verschiedene gehäuste und ungehäuste optoelektronische Bauelemente gemeinsam in einem optoelektronischen Modul verwendet werden können und eine Anordnung der optischen Bauteile zueinander in Normalenrichtung (z.B. Ausrichtung der optisch aktiven Flächen auf jeweils gleicher Höhe in Normalenrichtung sichergestellt werden kann. Dies kann eine kostengünstige Fertigung eines optoelektronischen Moduls trotz Verwendung von optischen Bauteilen mit unterschiedlichen Bauhöhen und Aufbautechniken ermöglichen.

Bevorzugte Ausführungsbeispiele der vorliegenden Erfindung werden nachfolgend bezugnehmend auf die beiliegenden Zeichnungen näher erläutert. Es zeigen:
- Fig. 1a: eine Seitenansicht einer Vorrichtung mit einem ersten optischen Bauteil auf einer ersten Leiterplattenfläche und einem zweiten optischen Bauteil auf einer zweiten Leiterplattenfläche, gemäß einem Ausführungsbeispiel der vorliegenden Erfindung;
- Fig. 1b: eine Draufsicht auf die in Fig. 1a dargestellte Vorrichtung;
- Fig. 1c: eine Seitenansicht einer Vorrichtung mit einem ersten optischen Bauteil auf einer ersten Leiterplattenfläche und einem zweiten optischen Bauteil auf einer zweiten Leiterplattenfläche, gemäß einem Vergleichsbeispiel der vorliegenden Erfindung;
- Fig. 2: eine Seitenansicht einer an eine optoelektrische Vorrichtung angekoppelte Faserleitung gemäß einem Ausführungsbeispiel der vorliegenden Erfindung;
- Fig. 3a-c: Seitenansichten zweier übereinander angeordneter Leiterplattenoberflächen gemäß Vergleichsbeispielen der vorliegenden Erfindung;
- Fig. 4: eine perspektivische Darstellung einer mit einer Öffnung versehenen ersten Leiterplatte mit einem in Chip-On-Board-Technik aufgebrachten optischen Bauteil und einer zweiten Leiterplatte mit einem in LO-Can-Technik ausgeführten optischen Bauteil;
- Fig. 5: ein optoelektronisches Sende-/Empfangsmodul gemäß einem Ausführungsbeispiel der vorliegenden Erfindung; und
- Fig. 6a: eine Seitenansicht eines Systems aus Faserleitung und Koppler; und
- Fig. 6b: eine Draufsicht auf den Koppler von der Faserleitung aus.

Bezüglich der nachfolgenden Beschreibung sollte beachtet werden, dass bei den unterschiedlichen Ausführungs- und Vergleichsbeispielen gleiche oder gleich wirkende Funktionselemente gleiche Bezugszeichen aufweisen und somit die Beschreibungen dieser Funktionselemente in den verschiedenen in den im Nachfolgenden dargestellten Ausführungsbeispielen untereinander austauschbar sind.

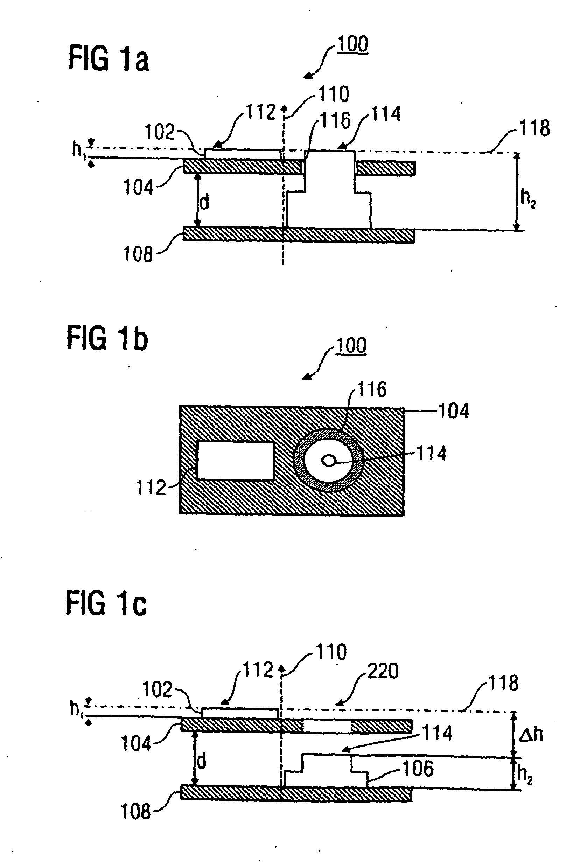

Fig. 1a zeigt eine Vorrichtung 100 mit einem ersten optischen Bauteil 102 auf einer ersten Leiterplattenfläche 104 und einem zweiten optischen Bauteil 106 auf einer zweiten Leiterplattenfläche 108, gemäß einem Ausführungsbeispiel der vorliegenden Erfindung.

Die erste Leiterplattenfläche 104 und die zweite Leiterplattenfläche 108 sind im Wesentlichen parallel zueinander hintereinander bzw. übereinander angeordnet, so dass die erste Leiterplattenfläche 104 und die zweite Leiterplattenfläche 108 in eine gleiche Normalenrichtung 110 weisen. Sowohl das erste optische Bauteil 102 als auch das zweite optische Bauteil 106 ist jeweils mit einer in Normalenrichtung 110 hinter bzw. über der ersten 104 und zweiten Leiterplattenfläche 108 liegenden optischen Schnittstelle optisch koppelbar. Die optische Schnittelle wird beispielsweise durch die Eintrittsfläche eines Wellenleiters gebildet oder durch die Eintrittsflächen mehrer Welleneiter, worunter beispielsweise einer als Wellenleiter für ankommende Informationen, d.h. als Empfangsfaser, und einer als Wellenleiter für außengerichtete Informationen, d.h. als Sendefaser, fungiert. Die optische Koppelbarkeit bedeutet beispielsweise, dass von der optischen Schnittstelle aus Lichtstrahlen sowohl eine Oberfläche des ersten optischen Bauteils 102 als auch eine Oberfläche des zweiten optischen Bauteils 106 erreichen können und umgekehrt. Dazu weist das erste optische Bauteil 102 eine optisch aktive End- bzw. Oberfläche 112 auf und das zweite optische Bauteil 106 weist eine optisch aktive End- bzw. Oberfläche 114 auf. Dabei sind mit den optisch aktiven Oberflächen 112, 114 Lichteintritts- und/oder Lichtaustrittsflächen gemeint. Bei einem in TO-Can-Technologie ausgeführten Laser ist die optisch aktive Fläche beispielsweise ein Glasfenster, aus dem ein Laserstrahl eines kantenemittierenden Lasers austreten kann. Bei einer in Chip-On-Board-Technologie aufgebrachten Fotodiode wird eine optisch aktive Fläche durch P-N-dotiertes Halbleitermaterial bzw. einen PN-Übergang gebildet.

Gemäß Ausführungsbeispielen ist die erste Leiterplattenfläche 104 und/oder die zweite Leiterplattenfläche 108 zumindest teilweise optisch transparent ausgebildet, um sowohl das erste optische Bauteil 102 als auch das zweite optische Bauteil 106 mit der in Normalenrichtung 110 hinter der ersten 104 und zweiten Leiterplattenfläche 108 liegenden optischen Schnittstelle optisch koppeln zu können. In anderen Worten ausgedrückt bedeutet das, dass auch auf der unteren Leiterplattenfläche 108 angebrachte optische Bauteile Licht von einer optischen Schnittstelle oberhalb der ersten Leiterplattenfläche 104 empfangen können bzw. Licht durch die erste Leiterplattenfläche 104 zu einer dahinterliegenden optischen Schnittstelle senden können.

Gemäß Ausführungsbeispielen können die Leiterplattenflächen 104, 108 dazu Öffnungen für jeweils darunter liegende optische Bauteile aufweisen. Somit können optische Bauteile von tiefer liegenden Leiterplattenflächen ganz oder teilweise in die darüber liegenden Leiterplattenflächen hineinragen, so wie es beispielhaft in Fig. 1a für das zweite optische Bauteil 106 gezeigt ist, welches durch eine Öffnung 116 in der ersten Leiterplattenfläche 104 über dieselbe hinausragt.

Mittels der in Fig. 1a exemplarisch dargestellten Ausführungsform der vorliegenden Erfindung kann erreicht werden, dass erste optische Bauteile 102 mit einer ersten optisch aktiven Fläche 112 in einer ersten Höhe h₁ von der ersten Leiterplattenfläche 104 und zweite optische Bauteile 106 mit einer zweiten optisch aktiven Fläche 114 in einer zweiten Höhe h₂ von der zweite Leiterplattenfläche 108, wobei die erste Höhe h₁ kleiner als die zweite Höhe h₂ ist, so angeordnet werden können, dass die erste optisch aktive Bauteiloberfläche 112 und die zweite optisch aktive Bauteiloberfläche 114 im Wesentlichen in einer gemeinsamen Ebene 118 liegen.

Bei der in Fig. 1a exemplarisch gezeigten Vorrichtung 100 könnte das erste optische Bauteil 102 beispielsweise eine mit der Chip-On-Board-Technik auf die erste Leiterplattenfläche 104 aufgebrachte Fotodiode sein und das zweite optische Bauteil 106 auf der zweiten Leiterplattenfläche 108 könnte ein mittels der TO-Can-Technik aufgebauter Laser sein. Durch die Öffnung 116 in der ersten Leiterplattenfläche 104 kann z.B. eine kantenemittierende Laserdiode des Lasers 106 mit wesentlich höherer Bauhöhe als die Fotodiode 102 verbaut werden. Der Laser 106 ist beispielsweise auf der zweiten Leiterplattenfläche 108 verlötet. Durch Veränderung eines Abstandes d zwischen den beiden Leiterplattenflächen 104 und 108 kann die Lage der optischen Bauteile 102 und 106 bzw. der optisch aktiven Bauteilflächen 112 und 114 zueinander verändert werden, so dass beide optisch aktiven Bauteilflächen 112, 114 auf der gewünschten gemeinsamen Referenzebene 118 liegen, um dort beispielsweise eine Aufnahme für einen optischen Steckverbinder zu positionieren.

Als Referenzebene 118 kann beispielsweise die erste Leiterplattenfläche 104, welche eine vorderste bzw. oberste Leiterplattenfläche darstellt, gewählt werden. Die Fotodiode 102 ist auf dieser Leiterplattenfläche 104 aufgebaut, der Laser 106 in TO-Can-Technologie kann beispielsweise durch ein Kunststoffteil in einer richtigen Höhe auf der zweiten Leiterplattenfläche 108 positioniert werden. Die in Fig. 1a dargestellte Vorrichtung bzw. Baugruppe kann beispielsweise mit Kunststoff gehäust bzw. umspritzt werden.

Eine Draufsicht der in Fig. 1a in einer Seitenansicht gezeigten Vorrichtung 100 gemäß einem Ausführungsbeispiel der vorliegenden Erfindung ist in Fig. 1b gezeigt.

Fig. 1b zeigt die erste bzw. obere Leiterplattenfläche 104, auf die das erste optische Bauteil 102 mit der ersten optisch aktiven Bauteiloberfläche 112 aufgebracht ist. Die erste Leiterplattenfläche 104 weist die Öffnung 116 für das zweite optische Bauteil 106 auf, welches auf der unteren Leiterplattenfläche 108 (nicht dargestellt) angebracht ist. Durch die Öffnung 116 ragt das zweite Bauteil 106 durch die erste Leiterplattenfläche 104 hindurch, wodurch die optisch aktive Bauteiloberfläche 114 des zweiten Bauteils 106 von einer optischen Schnittstelle überhalb der Zeichenebene aus optisch zugänglich wird.

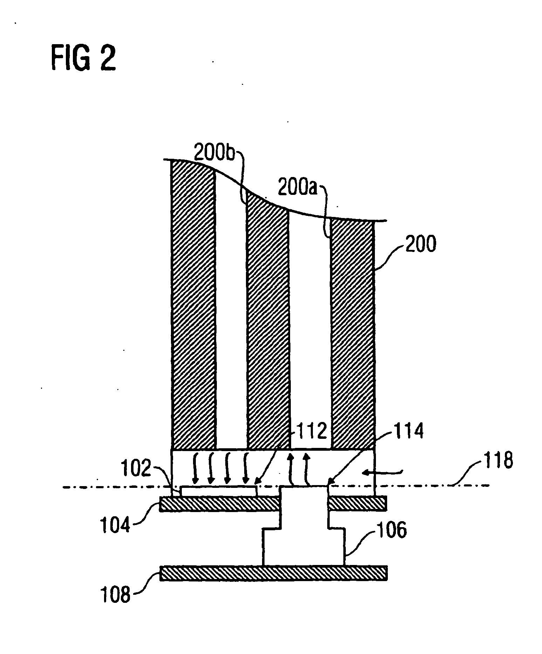

Wird die anhand der Fig. 1a und 1b beschriebene Vorrichtung 100 beispielsweise in einem optischen Transceiver verwendet, so kann an die erste Leiterplattenfläche 104 bzw. die Referenzebene 118, in der die beiden optisch aktiven Bauteiloberflächen 112, 114 liegen, beispielsweise eine optische Faserleitung angekoppelt werden. Dabei kann es sich z.B. um eine stumpfe Ankopplung handeln, wie es schematisch in Fig. 2 gezeigt ist. Ferner ist es möglich, dass die Faserleitung mehrere nebeneinander verlaufende interne Wellenleiter bzw. Fasern beherbergt, wie es ebenfalls exemplarisch in Fig. 2 gezeigt ist. So kann eine optische Faser für das eine optische Bauteil vorgesehen sein und eine andere für das andere optische Bauteil. Entgegen dem Beispiel von Fig. 2 wäre es aber auch möglich, dass eine Faser mit beiden optischen Bauteilen gekoppelt ist.

Fig. 2 zeigt schematisch die anhand von Fig. 1a,b beschriebene Vorrichtung, an die eine optische Faserleitung 200 angekoppelt ist. Dabei ist bei dem in Fig. 2 gezeigten Ausführungsbeispiel die optische Faserleitung 200 in der Referenzebene 118, in der die beiden optisch aktiven Bauteiloberflächen 112 und 114 liegen, stumpf an die beiden Bauteile 102 und 106 angekoppelt. Wie es gezeigt ist, kann es sein, dass sich Faserleitungsstirnfläche auf der einen und die optischen Bauteile 106 und 102 auf der anderen Seite über einen Spalt gegenüberliegen. Allerdings kann der Spalt auch fehlen, in welchem Fall Stirnfläche und optische Bauteile unmittelbar aufeinander lägen. Insbesondere liegen sich eine Stirnfläche der Faser 200 und insbesondere die Ein/Austrittsflächen einzelner interner Fasern 200a und 200b in der optischen Faserleitung 200 einerseits und die optisch aktiven Bauteiloberflächen 112, 114 andererseits unmittelbar gegenüber, um optische gekoppelt zu sein. Wie es im Vorhergehenden bereits beschrieben wurde, kann es sich gemäß Ausführungsbeispielen bei dem ersten Bauteil 102 um eine Fotodiode als optischen Empfänger handeln und bei dem zweiten optischen Bauteil 106 um einen optischen Sender in Form eines kantenemittierenden Lasers. Dabei dient ein optischer Empfänger im Allgemeinen zum Empfangen von Lichtleistung aus der optischen Faser 200 und zum Wandeln der empfangen Lichtleistung in elektrische Signale. Der optische Sender dient zum Wandeln von elektrischen Signalen in Lichtleistung, welche über eine optisch aktive Bauteiloberfläche in die Faser 200 einkoppelbar ist. Auf ähnliche Weise dient die Faser 200a als Sendefaser und die Faser 200b als Empfangsfaser. Natürlich könnte allerdings auch nur eine Faser im Inneren der Faserleitung vorgesehen sein, die mit beiden optischen Bauteilen sowohl für das Senden als auch für das Empfangen gekoppelt ist.

Selbstverständlich können zwischen die Stirnfläche der Faserleitung 200 und die optisch aktiven Bauteiloberflächen 112, 114 auch Optiken in Form von z.B. Linsen oder Linsenarrays angebracht werden, um einen Wirkungsgrad der optischen Ankopplung zwischen Vorrichtung 100 und optischer Faser 200 zu verbessern.

Gemäß Vergleichsbeispielen können die optisch aktiven Bauteiloberflächen 112, 114 auch in unterschiedlichen Ebenen liegen, so wie es exemplarisch in Fig. 1c gezeigt ist.

Liegt beispielsweise, so wie in Fig. 1c gezeigt, die zweite optisch aktive Bauteiloberfläche 114 des zweiten optischen Bauteils 106 unterhalb bzw. hinter der ersten Leiterplattenfläche 104, so weist diese, um eine optische Transparenz zu gewährleisten, eine transparente Stelle 220 auf, um die zweite optisch aktive Bauteiloberfläche 114 für eine optische Schnittstelle oberhalb der ersten Leiterplattenfläche 104 optisch zugänglich zu machen. Dabei kann es sich bei der optisch transparenten Stelle bzw. Aussparung 220 um eine einfache Lochöffnung, oder aber um eine in die Leiterplattenfläche 104 eingelassene oder auf die Leiterplattenfläche 104 aufgebrachte Optik in Form einer transparenten Ebene oder beispielsweise einer Linse handeln. Handelt es sich bei der transparenten Stelle 220 beispielsweise um eine Linse mit einer ersten Brennebene in der Referenzebene 118 und einer zweiten Brennebene, in der die zweite optisch aktive Bauteilfläche 114 liegt, so kann auch mit dem in Fig. 1c gezeigten Beispiel ein optischer Transceiver zur Ankopplung an eine optische Faser realisiert werden. Bei dem in Fig. 1c gezeigten Ausführungsbeispiel weisen die optische aktiven Bauteilflächen 112, 114 also einen definierten Höhenunterschied Δh bezüglich der Normalenrichtung 110 auf.

An dieser Stelle soll darauf hingewiesen werden, dass die in den Figuren eingezeichneten Bauteilhöhen h₁ und h₂ lediglich exemplarisch gemeint sind und davon natürlich variieren können.

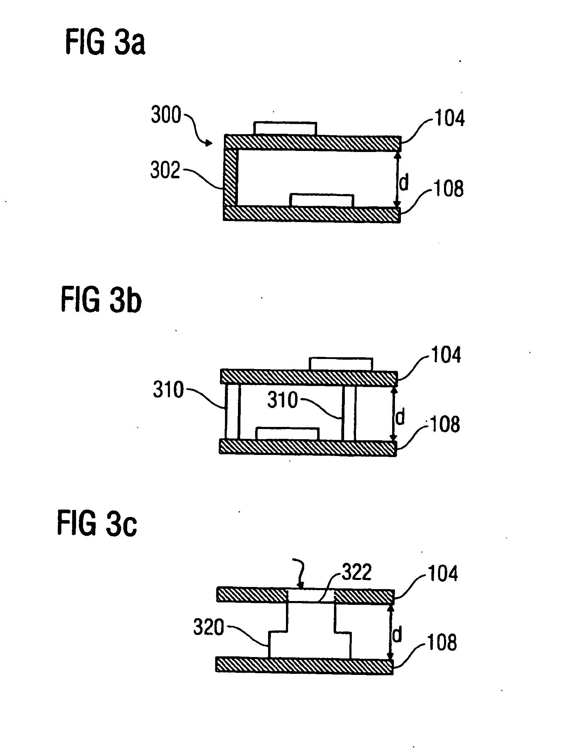

Im Folgenden soll anhand der Fig. 3a - 3c auf verschiedene Möglichkeiten gemäß Vergleichsbeispielen eingegangen werden, die erste Leiterplattenfläche 104 und die zweite Leiterplattenfläche 108 in einem vordefinierten Abstand d zueinander anzuordnen.

Fig. 3a zeigt eine Seitenansicht einer U-förmig geformten Leiterplatte 300 mit einer ersten Leiterplattenfläche 104 und einer zweiten Leiterplattenfläche 108. Die beiden Leiterplattenflächen 104, 108 werden von einer dritten Leiterplattenfläche 302 der Leiterplatte 300 in einem vordefinierten Abstand d zueinander gehalten. Dabei ist hervorzuheben, dass die dritte Leiterplattenfläche 302 nicht senkrecht zu den beiden Leiterplattenflächen 104 bzw. 108 verlaufen muss, sondern auch anders als in Fig. 3a dargestellt, angeordnet kann. So könnte die dritte Leiterplattenfläche 302 beispielsweise eine Bogenform aufweisen, welche z.B. durch ein Biegen der Leiterplatte 300 entstehen kann. Bei der in Fig. 3a gezeigten Ausführungsform handelt es sich also um eine geeignet gebogene flexible Leiterplatte 300, welche zwei im Wesentlichen parallele Leiterplattenabschnitte mit Leiterplattenflächen 104, 108 aufweist. Die Biegung kann beispielsweise durch Starr-Flex-Technik erzielt worden sein, und die so gebogene Leiterplatte kann beispielsweise an den der Biegekante gegenüberliegenden Seitenkanten durch einen Stecker gehalten werden, der für die elektrische Verbindung zu den opto-elektronischen Bauteilen und eventuellen anderen Bauteilen auf der Leiterplatte dient.

Die erste Leiterplattenfläche 104 und die zweite Leiterplattenfläche 108 werden also durch einander gegenüberliegende Außenoberflächen der gebogenen Leiterplatte 300 gebildet. Gemäß Ausführungsbeispielen ist die Leiterplatte 300 beidseitig bestückbar, d.h. Bauteile können auf einer Ober- oder/und Unterseite der Leiterplattenflächen 104, 108 angebracht werden.

Fig. 3b zeigt eine erste Leiterplatte mit einer ersten Leiterplattenfläche 104 und eine zweite Leiterplatte mit einer zweiten Leiterplattenfläche 108, wobei die beiden Leiterplatten separate Leiterplatten sind. Um die beiden Leiterplattenflächen 104, 108 der separaten Leiterplatten in einem vordefinierten Abstand d voneinander im Wesentlichen parallel zueinander zu halten, können geeignete Abstandshalter 310 zwischen den Leiterplattenflächen 104, 108 vorgesehen sein, sowie es in Fig. 3b angedeutet ist.

Fig. 3c zeigt zwei Leiterplattenflächen 104, 108 von separaten Leiterplatten, welche durch ein auf die untere bzw. hintere Leiterplattenfläche 108 aufgebrachtes Bauteil 320 in dem vordefinierten Abstand d im Wesentlichen parallel zueinander gehalten werden. Dabei kann die erste Leiterplatte bzw. die erste Leiterplattenfläche 104 auf eine Oberfläche 322 des Bauteils 320 beispielsweise aufgesteckt oder aufgeklebt sein. Ein Verlöten der Bauteiloberfläche 322 mit der Leiterplattenfläche 104 ist gleichermaßen denkbar. Handelt es sich bei der Bauteiloberfläche 322 um eine optisch aktive Bauteiloberfläche, so wird der über der optisch aktiven Oberfläche 322 liegende Bereich der Leiterplattenfläche 104 transparent ausgestaltet sein. Dazu bieten sich die bereits im Vorhergehenden beschriebenen Möglichkeiten (transparente Glasfläche, Linse, usw.) an.

Die anhand der Fig. 3a - 3c beschriebenen Techniken, um die beiden Leiterplattenflächen 104, 108 im Wesentlichen parallel in einem vorbestimmten Abstand d zueinander zu platzieren, sind lediglich ein kleiner Ausschnitt aus einer Vielzahl von Möglichkeiten, dies zu bewerkstelligen. Es sei also betont, dass die hier anhand der Fig. 3a - 3c exemplarisch aufgezeigten Ausführungen lediglich beispielhafter Natur sind.

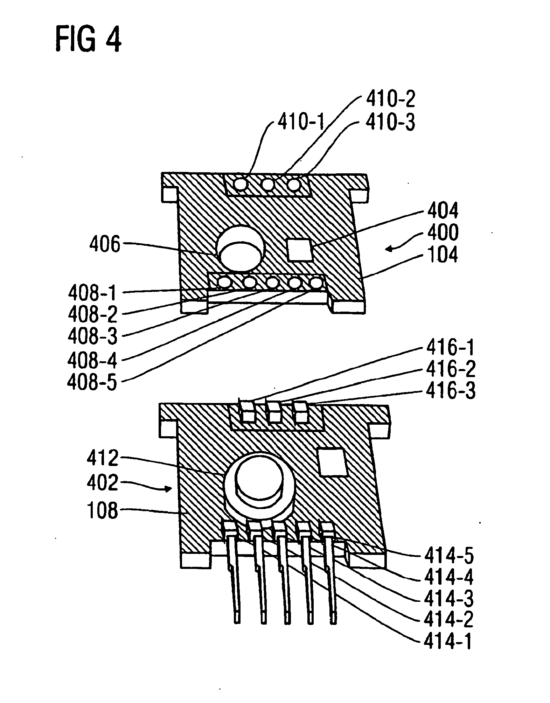

Fig. 4 zeigt eine perspektivische Ansicht von zwei separaten Leiterplatten 400 und 402.

Die erste Leiterplatte 400 weist auf einer ersten Leiterplattenfläche 104 eine in Chip-On-Board-Technik aufgebrachte Fotodiode 404 auf. Des Weiteren ist in die erste Leiterplatte 400 eine kreisförmige Öffnung 406 eingebracht. Ferner weist die erste Leiterplatte 400 fünf Aufnahmen 408-1 bis 408-5 für Abstandshalterstifte auf. Auf einer gegenüberliegenden Seite weist die erste Leiterplatte 400 weitere drei Aufnahmen 410-1 bis 410-3 für weitere Abstandshalterstifte auf.

Die zweite Leiterplatte 402 weist auf einer zweiten Leiterplattenfläche 108 einen Laser 412 in TO-Can-Technik auf. Ferner weist die zweite Leiterplatte 402 fünf Abstandshalterstifte 414-1 bis 414-5 auf, welche mit ihren Enden in die Aufnahmen 408-1 bis 408-5 der ersten Leiterplatte 400 greifen können. Zweite Abstandshalterstifte 416-1 bis 416-3 können mit ihren Enden in die dafür vorgesehene Aufnahmen 410-1 bis 410-3 der ersten Leiterplatte 400 greifen.

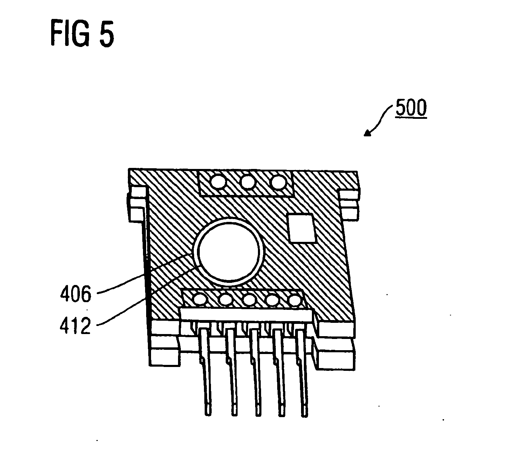

Wird die erste Leiterplatte 400 über der zweiten Leiterplatte 402 platziert, indem die Abstandshalterstifte 414-1 bis 414-5, 416-1 bis 416-3 in die jeweils dafür vorgesehenen Aufnahmen 408-1 bis 408-5, 410-1 bis 410-3 gesteckt werden, tritt die optisch aktive Fläche des Lasers 412 durch die dafür vorgesehene Kreisöffnung 406, wodurch die optisch aktive Fläche des Lasers 412 und die optisch aktive Fläche der Fotodiode 404 zumindest näherungsweise in einer Ebene liegen. Zur Fixierung der beiden Leiterplatten 400 und 402 können die Abstandshalterstifte 414-1 bis 414-5, 416-1 bis 416-3 mit den dafür vorgesehen Aufnahmen 408-1 bis 408-5, 410-1 bis 410-3 beispielsweise verlötet werden, so dass sich das in Fig. 5 dargestellte optoelektronische Sende-/Empfangsmodul 500 mit in unterschiedlicher Aufbautechnik realisiertem Laser 412 und Fotodiode 404 ergibt.

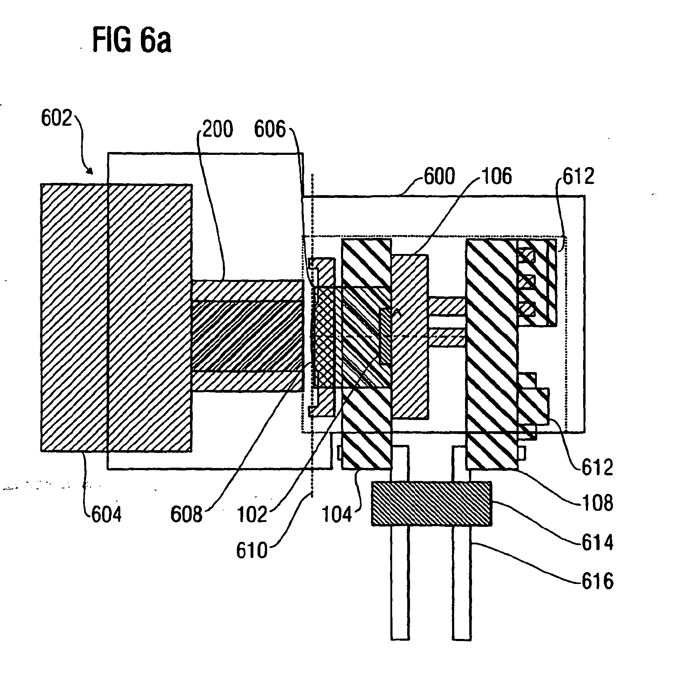

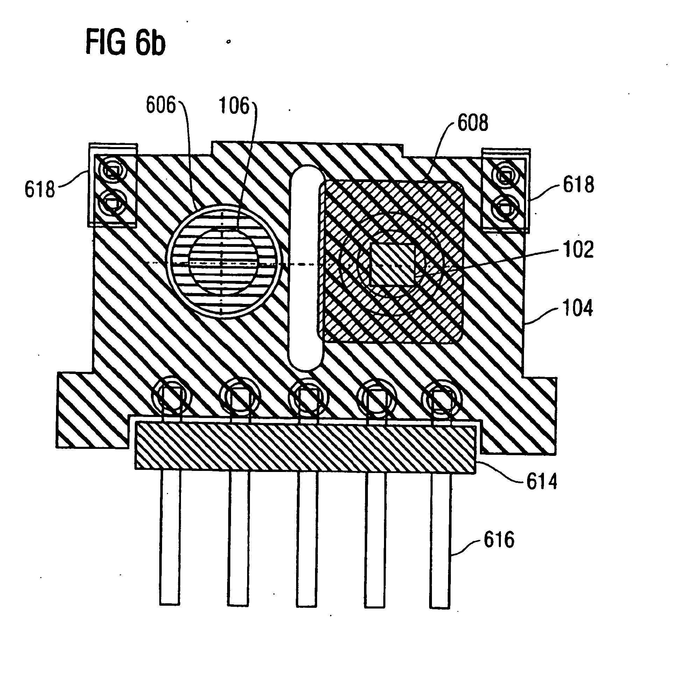

Fig. 6a und 6b zeigen ein weiteres Ausführungsbeispiel für eine Vorrichtung zur optischen Kopplung mit einer Faserleitung, wobei Fig. 6a den angekoppelten Zustand zeigt und Fig. 6b lediglich eine Aufsicht auf die Leiterplattenordnung zeigt. Wie es zu sehen ist, sind die Leiterplatten 104 und 108 hintereinanderliegend in einem Gehäuse 600 angeordnet, das eine Aufnahme 602 für eine Steckverbindung mit einem Ende der Faserleitung 200 aufweist. An dem Ende der Faserleitung 200 ist ein Stecker 604 vorgesehen, der mit der Aufnahme 602 der Gehäuses 600 zusammenpasst, um passgenau in die Aufnahme 602 zu passen. Die Aufnahme kann auch an dem Faserleitungsende vorgesehen sein. Es kann zudem eine geeignete Vorrichtung vorgesehen sein, die ein versehentliches Herausziehen der Faserleitung 200 aus der Aufnahme verhindern, wie z.B. eine Rasteinrichtung.

In dem eingesteckten Zustand der Faserleitung 200 befindet sich dieselbe beispielsweise in einem vorbestimmten Abstand zu den Vorderseiten der optischen Bauteile, der auch Null sein kann. In dem Ausführungsbeispiel von Fig. 6a befindet sich vor der Photodiode 102 eine optische Vorrichtung 606, wie z.B. eine Linse oder eine andere Strahlformungseinrichtung. In dem Fall von Fig. 6a sind die Leiterplatten 104 und 108 in einem derartigen Abstand zueinander in dem Gehäuse 600 angebracht, dass die Austrittsfläche der optischen Vorrichtung 606 und eine Fläche des Lasers 106 in einer Ebene 610 liegen, der die Stirnfläche der Faserleitung 200 in dem Fall gegenüberliegt, dass dieselbe eingesteckt ist.

Zusätzlich ist auf Fig. 6a und 6b ersichtlich, dass auf der Rückseite der Leiterplatte 108 auch andere elektrische Bauteile 612 angeordnet sein können, und dass ein elektrischer Stecker, der von einem Kunststoffteil 614 gehaltene Leiterstücke aufweisen kann, zumindest teilweise dazu beitragen kann, dass die Leiterplatten 104 und 108 ihre gegenseitige Lage bzw. ihren gegenseitigen Abstand beibehalten. Letzteres wird in Fig. 6b exemplarisch auch durch das Bauteil 106 erzielt. Dabei kann der elektrische Stecker mit dem Kunststoffabstandshalter 614 elektrische Leiter 616 aufweisen, die als Stifte zum Einführen in entsprechende Buchsen auf den Leiterplatten 104 und 108 oder als Buchsen für das Aufnehmen von entsprechenden Stiften an den Leiterplatten 104 und 108 ausgeführt sein können. Ferner sind in Fig. 6a Abstandshalter 618 zu sehen, die auch als elektrische Zwischenverbindungen zwischen Bauteilen auf den unterschiedlicen Leiterplatten 104 und 108 dienen können.

Gemäß Ausführungsbeispielen umfasst die vorliegende Erfindung ein Verfahren zum Anordnen einer ersten Leiterplattenfläche mit einem ersten optischen Bauteil und einer zweiten Leiterplattenfläche mit einem zweiten optischen Bauteil, so dass die erste und die zweite Leiterplattenfläche im Wesentlichen parallel zueinander hintereinander angeordnet sind, so dass die erste Leiterplattenfläche und die zweite Leiterplattenfläche in eine gleiche Normalenrichtung weisen, und so dass sowohl das erste optische Bauteil als auch das zweite optische Bauteil mit in einer in Normalenrichtung hinter der ersten und zweiten Leiterplattenoberfläche liegenden optischen Schnittstelle koppelbar sind. Der Übersichtlichkeit halber wurden im Vorhergehenden Ausführungsbeispiele exemplarisch lediglich anhand von zwei übereinander bzw. hintereinander angeordneten Leiterplattenflächen beschrieben. Eine Anordnung aus mehr als zwei übereinander bzw. hintereinander im Wesentlichen parallel zueinander angeordneten Leiterplattenflächen ist natürlich ebenfalls denkbar, wenn es eine entsprechende Anwendung erfordert. Dies kann z.B. dann der Fall sein, wenn mehr als zwei optische Bauteile mit jeweils unterschiedlicher Bauteilhöhe in einem optoelektrischen Modul verbaut werden sollen.

Ausführungsbeispiele der vorliegenden Erfindung ermöglichen eine kostengünstige Aufbautechnik, beispielsweise für optische Transceiver, mit der es möglich ist, optische Bauteile unterschiedlicher Bauteilhöhe zu verbauen, die jedoch eine definierte Justage von optisch aktiven Bauteiloberflächen in Normalenrichtung benötigen, wie es beispielsweise bei optoelektrische Hybridaufbauten als Kombination von TO-Can-Technik und Chip-on-Board-Technik der Fall sein kann.

Bei der vorliegenden Erfindung können optisch aktive Bauteiloberflächen optischer Bauteile in gleicher Höhe in einem Modul angebracht werden, um beispielsweise einen optischen Stecker in einfacher Weise mit dem Modul verbinden zu können. Dies wird gemäß Ausführungsbeispielen durch einen definierten Abstand d von Leiterplatten bzw. Leiterplattenflächen, auf denen die optischen Bauteile unterschiedlicher Bauteilhöhe montiert sind, erreicht. Ausführungsbeispiele der vorliegenden Erfindung ermöglichen es, trotz eines Höhenunterschieds, sowohl oberflächenaktive Chip-On-Board Bauelemente (z.B. Fotodioden) als auch kantenaktive TO-Can-Bauelemente (z.B. Laser) in einem optoelektrischen Modul zu verwenden und dabei gleichzeitig alle optischen Bauteile in derselben Höhe bzw. in einem definierten Höhenunterschied Δh bezüglich der Normalenrichtung zueinander anzuordnen.

## Patentansprüche

1. Vorrichtung mit
einem ersten opto-elektronischen Bauteil (102) auf einer ersten Leiterplattenfläche (104), wobei das erste opto-elektronische Bauteil (102) eine erste optisch aktive Fläche (112) in einer ersten Höhe (h₁) von der ersten Leiterplattenfläche (104) aufweist, und wobei die erste Leiterplattenfläche (104) eine Öffnung (116) aufweist;
einem zweiten opto-elektronischen Bauteil (106) auf einer zweiten Leiterplattenfläche (108), wobei das zweite opto-elektronische Bauteil (106) eine zweite optisch aktive Fläche (114) in einer zweiten Höhe (h₂) von der zweiten Leiterplattenfläche (108) aufweist, wobei die erste Höhe verschieden von der zweiten Höhe ist; und
wobei die erste Leiterplattenfläche (104) und die zweite Leiterplattenfläche (108) parallel zueinander hintereinander so angeordnet sind, dass
die erste Leiterplattenfläche (104) und die zweite Leiterplattenfläche (108) in eine gleiche Normalenrichtung (110) weisen, und
das erste opto-elektronische Bauteil (102) auf der ersten Leiterplattenfläche (104) gegenüber dem zweiten opto-elektronischen Bauteil (106) lateral versetzt angeordnet ist, und
wobei die erste Leiterplattenfläche (104) und die zweite Leiterplattenfläche (108) so voneinander beabstandet sind, dass
das zweite opto-elektronische Bauteil (106) durch die Öffnung (116) in der ersten Leiterplattenfläche (104) über dieselbe hinausragt, und
eine erste optisch aktive Fläche (112) des ersten optischen Bauteils (102) und eine zweite optisch aktive Fläche (114) des zweiten optischen Bauteils (106) in einer Ebene (118) liegen, so dass sowohl das erste opto-elektronische Bauteil (102) als auch das zweite opto-elektronische Bauteil (106) mit einer in Normalenrichtung (110) hinter der ersten und der zweiten Leiterplattenfläche liegenden, der ersten und zweiten optisch aktiven Fläche gegenüberliegenden optischen Schnittstelle koppelbar sind.

2. Vorrichtung gemäß Anspruch 1, bei der die erste Leiterplattenfläche (104) und die zweite Leiterplattenfläche (108) durch einander gegenüberliegende Außenoberflächen einer gebogenen Leiterplatte (300) gebildet sind.

3. Vorrichtung gemäß Anspruch 1, bei der sich in der Ebene (118) oder einer hierzu parallelen Ebene eine Stirnfläche einer optischen Faserleitung (200) befindet.

4. Vorrichtung gemäß einem der vorhergehenden Ansprüche, bei der das erste opto-elektronische Bauteil (102) mittels einer Chip-On-Board-Technik auf die erste Leiterplattenfläche (104) aufgebracht ist.

5. Vorrichtung gemäß einem der vorhergehenden Ansprüche, bei der das zweite opto-elektronische Bauteil (106) mittels einer TO-Can-Technik auf die zweite Leiterplattenfläche (108) aufgebracht ist.

6. Vorrichtung gemäß einem der vorhergehenden Ansprüche, bei der das erste opto-elektronische Bauteil (102) ein opto-elektronischer Empfänger ist.

7. Vorrichtung gemäß Anspruch 6, bei der der optoelektronische Empfänger eine Fotodiode in Chip-On-Board-Technik aufweist.

8. Vorrichtung gemäß einem der vorhergehenden Ansprüche, bei der das zweite opto-elektronische Bauteil (106) ein opto-elektronischer Sender ist.

9. Vorrichtung gemäß Anspruch 8, bei der der optoelektronische Sender einen Laser in TO-Can-Technik aufweist.

10. System mit
einer Vorrichtung gemäß einem der Ansprüche 1 bis 9; und
einem Gehäuse, das eine Aufnahme für eine Steckerverbindung mit einem Ende einer Faserleitung (200) aufweist, wobei die erste Leiterplattenfläche (104) und die zweite Leiterplattenfläche (108) der Vorrichtung so an dem Gehäuse angebracht sind, dass die Faserleitung sowohl mit dem ersten als auch dem zweiten optoelektronischen Bauteil gekoppelt ist.

11. Satz mit einem System gemäß Anspruch 10 und einer Faserleitung.

12. Verfahren mit folgendem Schritt:
Anordnen einer ersten Leiterplattenfläche (104) mit einem ersten opto-elektronischen Bauteil (102), das eine erste optisch aktive Fläche (112) in einer ersten Höhe (h₁) von der ersten Leiterplattenfläche (104) aufweist, und einer Öffnung (116) und einer zweiten Leiterplattenfläche (108) mit einem zweiten optoelektronischen Bauteil (106), das eine zweite optisch aktive Fläche (114) in einer zweiten Höhe (h₂) von der zweiten Leiterplattenfläche (108) aufweist, die verschieden von der ersten Höhe ist, so dass die erste und die zweite Leiterplattenfläche parallel zueinander hintereinander angeordnet sind, so dass die erste Leiterplattenfläche (104) und die zweite Leiterplattenfläche (108) in eine gleiche Normalenrichtung (110) weisen, und das erste opto-elektronische Bauteil (102) auf der ersten Leiterplattenfläche (104) gegenüber dem zweiten opto-elektronischen Bauteil (106) lateral versetzt angeordnet ist, und so, dass die erste Leiterplattenfläche (104) und die zweite Leiterplattenfläche (108) so voneinander beabstandet sind, dass das zweite opto-elektronische Bauteil (106) durch die Öffnung (116) in der ersten Leiterplattenfläche (104) über dieselbe hinausragt, und eine erste optisch aktive Fläche (112) des ersten optischen Bauteils (102) und eine zweite optisch aktive Fläche (114) des zweiten optischen Bauteils (106) in einer Ebene (118) liegen, so dass sowohl das erste opto-elektronische Bauteil (102) als auch das zweite opto-elektronische Bauteil (106) mit einer in Normalenrichtung (110) hinter der ersten und zweiten Leiterplattenfläche liegenden, der ersten und zweiten optisch aktiven Fläche gegenüberliegenden optischen Schnittstelle koppelbar sind.

## Claims

1. Apparatus comprising:
a first optoelectronic component (102) on a first printed circuit board surface (104), the first optoelectronic component (102) having a first optically active area (112) at a first height (h₁) from the first printed circuit board surface (104), and the first printed circuit board surface (104) having an opening (116);
a second optoelectronic component (106) on a second printed circuit board surface (108), the second optoelectronic component (106) having a second optically active area (114) at a second height (h₂) from the second printed circuit board surface (108), the first height being different from the second height; and
the first printed circuit board surface (104) and the second printed circuit board surface (108) being arranged in series and in parallel to one another such that
the first printed circuit board surface (104) and the second printed circuit board surface (108) point in a same normal direction (110), and
the first optoelectronic component (102) is arranged, on the first printed circuit board surface (104), in a laterally offset manner in relation to the second optoelectronic component (106), and
the first printed circuit board surface (104) and the second printed circuit board surface (108) are spaced apart from each other such that
the second optoelectronic component (106) projects beyond the first printed circuit board surface (104) through the opening (116) within the latter, and
a first optically active area (112) of the first optical component (102) and a second optically active area (114) of the second optical component (106) lying within a plane (118), so that both the first optoelectronic component (102) and the second optoelectronic component (106) may be coupled to an optical interface that is located, in the normal direction (110), behind the first and second printed circuit board surfaces and is opposite the first and second optically active areas.

2. Apparatus as claimed in claim 1, wherein the first printed circuit board surface (104) and the second printed circuit board surface (108) are formed by mutually opposite outer surfaces of a curved printed circuit board (300).

3. Apparatus as claimed in claim 1, wherein an end face of an optical fiber (200) is located within the plane (118) or a plane parallel thereto.

4. Apparatus as claimed in any of the previous claims, wherein the first optoelectronic component (102) is mounted onto the first printed circuit board surface (104) by means of Chip-on-Board technology.

5. Apparatus as claimed in any of the previous claims, wherein the second optoelectronic component (106) is mounted onto the second printed circuit board surface (108) by means of TO-Can technology.

6. Apparatus as claimed in any of the previous claims, wherein the first optoelectronic component (102) is an optoelectronic receiver.

7. Apparatus as claimed in claim 6, wherein the optoelectronic receiver comprises a photodiode in Chip-on-Board technology.

8. Apparatus as claimed in any of the previous claims, wherein the second optoelectronic component (106) is an optoelectronic transmitter.

9. Apparatus as claimed in claim 8, wherein the optoelectronic transmitter comprises a laser in TO-Can technology.

10. System comprising
an apparatus as claimed in any of claims 1 to 9; and
a housing comprising a receptacle for a plug connection to one end of a fiber (200), the first printed circuit board surface (104) and the second printed circuit board surface (108) of the apparatus being mounted on the housing such that the fiber is coupled both to the first and to the second optoelectronic components.

11. Kit comprising a system as claimed in claim 10 and a fiber.

12. Method comprising:
arranging a first printed circuit board surface (104) comprising a first optoelectronic component (102) which has a first optically active area (112) at a first height (h₁) from the first printed circuit board surface (104), and comprising an opening (116), and a second printed circuit board surface (108) comprising a second optoelectronic component (106) which has a second optically active area (114) at a second height (h₂) from the second printed circuit board surface (108), which is different from the first height, so that the first and the second printed circuit board surfaces are arranged in series and in parallel to one another so that the first printed circuit board surface (104) and the second printed circuit board surface (108) point in a same normal direction (110), and the first optoelectronic component (102) is arranged, on the first printed circuit board surface (104), opposite the second optoelectronic component (106) in a laterally offset manner, and so that the first printed circuit board surface (104) and the second printed circuit board surface (108) are spaced apart from each other such that the second optoelectronic component (106) projects beyond the first printed circuit board surface (104) through the opening (116) within the latter, and a first optically active area (112) of the first optical component (102) and a second optically active area (114) of the second optical component (106) lying within a plane (118), so that both the first optoelectronic component (102) and the second optoelectronic component (106) may be coupled to an optical interface that is located, in the normal direction (110), behind the first and second printed circuit board surfaces and is opposite the first and second optically active areas.

## Revendications

1. Dispositif avec
un premier bloc optoélectronique (102) sur une première face de plaque conductrice (104), le premier bloc optoélectronique (102) présentant une première face optiquement active (112) à une première hauteur (h₁) à partir de la première face de plaque conductrice (104), et la première face de plaque conductrice (104) présentant une ouverture (116);
un deuxième bloc optoélectronique (106) sur une deuxième face de plaque conductrice (108), le deuxième bloc optoélectronique (106) présentant une deuxième face optiquement active (114) à une deuxième hauteur (h₂) à partir de la deuxième face de plaque conductrice (108), la première hauteur étant différente de la deuxième hauteur; et
la première face de plaque conductrice (104) et la deuxième face de plaque conductrice (108) étant disposées l'une derrière l'autre, parallèles entre elles, de sorte que
la première face de plaque conductrice (104) et la deuxième face de plaque conductrice (108) soient orientées dans une même direction normale (110), et
que le premier bloc optoélectronique (102) sur la première face de plaque conductrice (104) soit disposé déplacé latéralement par rapport au deuxième bloc optoélectronique (106), et
la première face de plaque conductrice (104) et la deuxième face de plaque conductrice (108) étant distantes l'une de l'autre de sorte que
le deuxième bloc optoélectronique (106) fasse saillie, à travers l'ouverture (116) dans la première face de plaque conductrice (104), au-delà de cette dernière, et
une première face optiquement active (112) du premier bloc optoélectronique (102) et une deuxième face optiquement active (114) du deuxième bloc optoélectronique (106) se situent dans un plan (118), de sorte que tant le premier bloc optoélectronique (102) que le deuxième bloc optoélectronique (106) puissent être couplés à une interface optique située, dans la direction normale (110), derrière la première et la deuxième face de plaque conductrice, opposée à la première et la deuxième face optiquement active.

2. Dispositif selon la revendication 1, dans lequel la première face de plaque conductrice (104) et la deuxième face de plaque conductrice (108) sont formées par des surfaces extérieures opposées l'une à l'autre d'une plaque conductrice courbée (300).

3. Dispositif selon la revendication 1, dans lequel se trouve, dans le plan (118) ou dans un plan parallèle à ce dernier, une face frontale d'un premier câble à fibre optique (200).

4. Dispositif selon l'une des revendications précédentes, dans lequel le premier bloc optoélectronique (102) est placé sur la première face de plaque conductrice (104) à l'aide d'une technique à puce-sur-plaquette.

5. Dispositif selon l'une des revendications précédentes, dans lequel le deuxième bloc optoélectronique (106) est placé sur la deuxième face de plaque conductrice (108) à l'aide d'une technique TO-Can.

6. Dispositif selon l'une des revendications précédentes, dans lequel le premier bloc optoélectronique (102) est un récepteur optoélectronique.

7. Dispositif selon la revendication 6, dans lequel le récepteur optoélectronique présente une photodiode selon la technique à puce-sur-plaquette.

8. Dispositif selon l'une des revendications précédentes, dans lequel le deuxième bloc optoélectronique (106) est un émetteur optoélectronique.

9. Dispositif selon la revendication 8, dans lequel l'émetteur optoélectronique présente un laser selon la technique TO-Can.

10. Système avec
un dispositif selon l'une des revendications 1 à 9; et
un boîtier présentant un dispositif de réception d'une connexion enfichable avec une extrémité d'un câble à fibre (200), la première face de plaque conductrice (104) et la deuxième face de plaque conductrice (108) du dispositif étant placées sur le boîtier de sorte que le câble à fibre soit couplé tant au premier qu'au deuxième bloc optoélectronique.

11. Ensemble avec un système selon la revendication 10 et un câble à fibre.

12. Procédé à l'étape suivante:
disposer une première face de plaque conductrice (104) avec un premier bloc optoélectronique (102) présentant une première face optiquement active (112) à une première hauteur (h₁) à partir de la première face de plaque conductrice (104), et une ouverture (116) et une deuxième face de plaque conductrice (108) avec un deuxième bloc optoélectronique (106) présentant une deuxième face optiquement active (114) à une deuxième hauteur (h₂) à partir de la première face de plaque conductrice (108) qui est différente de la deuxième hauteur, de sorte que la première et la deuxième face de plaque conductrice soient disposées l'une derrière l'autre, parallèles entre elles, de sorte que la première face de plaque conductrice (104) et la deuxième face de plaque conductrice (108) soient orientées dans une même direction normale (110), et que le premier bloc optoélectronique (102) sur la première face de plaque conductrice (104) soit disposé déplacé latéralement par rapport au deuxième bloc optoélectronique (106),
et de sorte que la première face de plaque conductrice (104) et la deuxième face de plaque conductrice (108) soient distantes l'une de l'autre de sorte que le deuxième bloc optoélectronique (106) fasse saillie, à travers l'ouverture (116) dans la première face de plaque conductrice (104), au-delà de cette dernière, et une première face optiquement active (112) du premier bloc optoélectronique (102) et une deuxième face optiquement active (114) du deuxième bloc optoélectronique (106) se situent dans un plan (118), de sorte que tant le premier bloc optoélectronique (102) que le deuxième bloc optoélectronique (106) puissent être couplés à une interface optique située, dans la direction normale (110), derrière la première et la deuxième face de plaque conductrice, opposée à la première et la deuxième face optiquement active.
